# EUROPÄISCHE PATENTANMELDUNG

(11) **EP 3 002 602 A1**
(43) Veröffentlichungstag der Anmeldung: **06.04.2016**
(21) Anmeldenummer: 15187563.0
(22) Anmeldetag: 30.09.2015
(51) Int. Cl.: G01R 33/54, G01R 33/3875

(54) **BETRIEB EINES BILDGEBENDEN MEDIZINISCHEN UNTERSUCHUNGSGERÄTS MIT EINER MEHRZAHL AN TEILSYSTEMEN**

(30) Priorität: 30.09.2014 DE 102014219778
(71) Anmelder: Siemens Aktiengesellschaft, 80333 München (DE)
(72) Erfinder: Campagna, Swen, 91238 Engelthal (DE); Feiweier, Thorsten, 91099 Poxdorf (DE); Stöcker, Stephan, 91083 Baiersdorf (DE); Sukkau, Johann, 91074 Herzogenaurach (DE); Wullenweber, Michael, 91052 Erlangen (DE); Benner, Thomas, 91052 Erlangen (DE); Kühn, Bernd, 91080 Uttenreuth (DE); Löffler, Thomas, 91207 Lauf a.d. Pegnitz (DE); Speckner, Thorsten, 91058 Erlangen (DE); Speier, Peter, 91056 Erlangen (DE); Splitthoff, Daniel Nico, 91052 Erlangen (DE)

(57) **Zusammenfassung**

Es wird ein Verfahren zum Betrieb eines bildgebenden medizinischen Untersuchungsgeräts mit einer Mehrzahl an Teilsystemen und einer Steuereinrichtung, welche die Teilsysteme zur Durchführung einer Messsequenz koordiniert ansteuert, beschrieben, das die folgenden Schritte umfasst:
- Übermitteln eines zu einer durchzuführenden Messung zugeordneten Steuerprotokolls an die Steuereinrichtung,
- Bestimmen von für das Steuerprotokoll relevanten Sequenzsteuerdaten, welche verschiedene funktionelle Teilsequenzen einer zu dem Steuerprotokoll gehörigen Messsequenz definieren,
- Zuordnen von unterschiedlichen Wirkvolumina zu jeder funktionellen Teilsequenz,
- Bestimmen von für die bestimmten relevanten Sequenzsteuerdaten und zugeordneten Wirkvolumina maßgeblichen, aktuellen Umgebungsbedingungen des bildgebenden medizinischen Untersuchungsgeräts,
- Berechnen und Speichern von Steuersignalen für die Messsequenz auf Basis der bestimmten Sequenzsteuerdaten, der Wirkvolumina und der bestimmten aktuellen Umgebungsbedingungen, derart dass die funktionellen Teilsequenzen der Messsequenz zumindest hinsichtlich eines Teilbereichs ihres zugeordneten Wirkvolumens lokal optimiert werden,
- Starten einer Messung gemäß dem Steuerprotokoll unter Verwendung der gespeicherten Steuersignale.

## Beschreibung

Die Erfindung betrifft ein Verfahren zum Betrieb eines bildgebenden medizinischen Untersuchungsgeräts mit einer Mehrzahl an Teilsystemen sowie ein entsprechendes bildgebendes medizinisches Untersuchungsgerät und ein zugehöriges Computerprogramm sowie einen zugehörigen elektronisch lesbaren Datenträger.

Bei bildgebenden medizinischen Untersuchungsgeräten, wie beispielsweise Magnetresonanzgeräten oder Computertomographen, handelt es sich um komplexe Einrichtungen mit einer Vielzahl von technischen Teilsystemen. Hierzu gehören beispielsweise bei einem Magnetresonanzgerät ein Grundfeldmagnetsystem, ein Gradientensystem, ein Shim-System und ein Hochfrequenzsendesystem sowie ein Hochfrequenzempfangssystem.

Um Bilder oder spektroskopische Daten von einem Untersuchungsobjekt mit einem Magnetresonanzgerät zu generieren, wird das Untersuchungsobjekt in einem durch das Grundfeldmagnetsystem erzeugten, starken, homogenen Grundmagnetfeld, auch B₀-Feld genannt, mit Feldstärken von 0,2 Tesla bis 7 Tesla und mehr positioniert, sodass sich dessen Kernspins entlang des Grundmagnetfeldes orientieren. Zum Auslösen von Kernspinresonanzen werden mit geeigneten Antenneneinrichtungen des Hochfrequenzsendesystems hochfrequente Anregungssignale (HF-Pulse) in das Untersuchungsobjekt eingestrahlt, sodass die Kernspins bestimmter, durch dieses Hochfrequenzfeld resonant angeregter Atome um einen bestimmten Flipwinkel gegenüber den Magnetfeldlinien des Grundmagnetfelds verkippt werden. Die ausgelösten Kernspinresonanzen, d.h. die bei der Präzession der Kernspins abgestrahlten Hochfrequenzsignale (auch: die Magnetresonanzsignale), werden mittels des Hochfrequenzempfangssystems gemessen, in der Regel digitalisiert und als komplexe Zahlenwerte zumeist (wenn ein Ortsbezug gegeben ist) in einer sogenannten k-Raum-Matrix, als sogenannte k-Raumdaten, abgelegt. Beispielsweise bei Single-Voxel-Spektroskopie-Messungen (ohne Ortsbezug) werden die digitalisierten Daten als komplexe Zeitsignale, auch "FID-Daten" genannten, gespeichert. Auf Basis der k-Raumdaten oder FID-Daten können MR-Bilder rekonstruiert oder Spektroskopiedaten ermittelt werden. Zur Ortskodierung der Messdaten werden dem Grundmagnetfeld mittels des Gradientensystems schnell geschaltete magnetische Gradientenfelder überlagert. Das Shim-System soll die Magnetfelder homogenisieren.

Alle diese technischen Module müssen von einer Steuerung in geeigneter Art und Weise koordiniert angesprochen werden. Dabei müssen durch die Ansteuerung die für einen bestimmten Bildgebungsprozess notwendigen Einstellungen und Schaltungen der einzelnen Teilsysteme zum jeweils richtigen Zeitpunkt vorgenommen werden. Üblicherweise wird innerhalb eines Bildgebungsablaufs das abzubildende Volumen in Teilvolumina, beispielsweise bei der 2D-Bildgebung in mehreren Schichten oder bei der 3D-Bildgebung in sogenannten mehreren "Slabs", aufgenommen. Die so aufgenommenen Teilvolumina werden dann zu einem Gesamtvolumen zusammengesetzt. Eine weitere Definition von Teilvolumina kann sich beispielsweise durch vom Bediener speziell definierbare "Regions of Interest" (ROI), oder auch "Volumes of Interest" (VOI), ergeben. Weiterhin ergeben sich beispielsweise bei Magnetresonanzsystemen zusätzliche Teilvolumina bei der Festlegung lokaler Sättigungsregionen oder lokaler Präparations- oder Labeling-Pulsen.

Wie bereits erwähnt, werden der Steuereinrichtung zur koordinierten Ansteuerung üblicherweise Sequenzsteuerdaten, meist basierend auf einem sogenannten Messprotokoll, übermittelt. Diese Sequenzsteuerdaten definieren verschiedene funktionelle Teilsequenzen einer kompletten Messsequenz. Bei einer Magnetresonanzaufnahme kann es sich beispielsweise bei einer ersten Teilsequenz um eine Pulssequenz handeln, um lokal in einem bestimmten Bereich eine Sättigung zu erreichen. Weitere Teilsequenzen können beispielsweise bestimmte Präparationspulse enthalten und wieder andere Teilsequenzen dienen zur sukzessiven Anregung und zum Empfang der Magnetresonanzsignale in verschiedenen Schichten oder Slabs.

Übliche Verfahren auf Grundlage der MR-Technik, wie die tomographische Bildgebung (MRT, engl. "magnetic resonance tomography") oder die Spektroskopie (MRS, engl. "magnetic resonance spectroscopy"), benötigen "gutartige" physikalische Umgebungsbedingungen, um eine möglichst gute Qualität der aufgenommenen Daten zu gewährleisten. Beispielsweise betrifft dies die räumliche Homogenität, zeitliche Stabilität und die absolute Genauigkeit der relevanten magnetischen Felder und Hochfrequenzfelder, also des Grundmagnetfeldes (B₀) und der Gradienten- und Hochfrequenzfelder (B₁).

Bisher können Abweichungen von idealen Umgebungsbedingungen zumindest teilweise, z.B. durch systemspezifische Einstellungen, sogenannte "Tune-Ups", insbesondere hinsichtlich wirbelstrominduzierter dynamischer Feldstörungen oder Gradientensensitivitäten, oder durch untersuchungsobjekt-spezifische Einstellungen, insbesondere hinsichtlich suszeptibilitätsbedingten statischen Feldstörungen oder räumlichen Variationen des Hochfrequenzfeldes, kompensiert werden. Dabei bleiben allerdings die vor Beginn einer Messung festgelegten Kompensationseinstellungen üblicherweise während der gesamten Messung gültig ("statische" Justierung).

Für räumlich variable Umgebungsbedingungen, die nicht vollständig kompensiert werden können, bedeutet dies einen Kompromiss für die Datenqualität.

De Graaf et al. beschreiben in "Dynamic Shim Updating (DSU) for Multi-Slice Signal Acquisition", Proc. Intl. Soc. Mag. Reson. Med. 10, S. 536, 2002, eine rudimentäre Form einer dynamischen Justierung der Shim-Ströme der Feldspulen für den B0-Shim in der funktionalen Mehrschicht-MR-Bildgebung. Dazu wird eine dezidierte Feldbestimmungssequenz zur Ermittlung von räumlichen Feldänderungen erster oder höherer Ordnung aufgesetzt, die exakt an die entsprechenden Parameter (z.B. Schichtpositionen und -orientierungen) der gewünschten Bildgebungssequenz angepasst sein müssen. Die Feldbestimmungssequenz nimmt die zur Feldbestimmung notwendigen Daten auf und analysiert diese, um daraus optimierte Shim-Ströme (erster oder höherer Ordnung) für jede mit der Bildgebungssequenz zu messende Schicht zu berechnen. Anschließend wird die Bildgebungssequenz mit den optimierten Shim-Strömen gestartet. Hierbei ist durch den Benutzer sehr genau auf Konsistenz zwischen Bildgebungssequenz und Feldbestimmungssequenz zu achten, da ansonsten Inkonsistenzen zu einer Verschlechterung der Bildqualität führen. Daher ist auch für jede Bildgebungssequenz und jede Änderung einer solchen, erneut eine Feldbestimmungssequenz zu erstellen und vor der Messung mit der Bildgebungssequenz durchzuführen. Diese Verfahren sind somit für den Anwender sehr komplex und schwer mit anderen, z.B. statischen, Justierungen zu kombinieren, da sich Wechselwirkungen zwischen verschiedenen Parametern nicht oder nur eingeschränkt berücksichtigen lassen. Werden statisch justierte Parameter geändert, kann dies Auswirkungen auf die optimalen dynamischen Einstellungen der Shim-Ströme haben und eine erneute Durchführung der Feldbestimmungssequenz und Berechnung der optimierten Shim-Ströme wäre durchzuführen. Darüber hinaus ist die Optimierung hier auf die Schichten der Bildgebungssequenz beschränkt. Kleinere Volumina, z.B. regionale Sättigungsvolumina, werden hier nicht berücksichtigt.

In der DE 10 2009 020 661 B4 ist wiederum ein Verfahren beschrieben, mit dem Parameter einer Messsequenz, z.B. in der Magnetresonanztechnik, zur Laufzeit der Messsequenz angepasst werden. Darüber hinaus wird hier bereits beschrieben, dass verschiedenen funktionellen Teilsequenzen in der Regel unterschiedliche Wirkvolumina zugeordnet sind. D. h. für jede Teilsequenz ist ein anderes Teilvolumen des gesamten Messvolumens relevant. Durch die Ermittlung der Parameter zur Laufzeit kann es allerdings vorkommen, dass in der hier wegen der bereits laufenden Messung durch die Messsequenz nur begrenzt zur Verfügung stehenden Zeit keine sinnvollen Parameter ermittelt werden können. In diesem Fall kann nur entweder die Messung insgesamt abgebrochen werden oder es wird auf suboptimale, statische Parameter zurückgegriffen.

Der Erfindung liegt daher die Aufgabe zugrunde, ein Verfahren zum Betrieb eines bildgebenden medizinischen Untersuchungsgeräts mit einer Mehrzahl an Teilsystemen und einer Steuereinrichtung, welche die Teilsysteme zur Durchführung einer Messsequenz koordiniert ansteuert, ein bildgebendes medizinisches Untersuchungsgerät, ein zugehöriges Computerprogrammprodukt sowie einen zugehörigen elektronisch lesbaren Datenträger anzugeben, welche eine Anpassung von Sequenzsteuerdaten an vorliegende Umgebungsbedingungen (Justierung) zuverlässig, anwenderfreundlich und zeitoptimiert erlaubt und die oben genannten Nachteile bisheriger Verfahren überwindet.

Der Erfindung liegt unter anderem die Überlegung zugrunde, dass bei Messungen, in denen sich das für die Signalanregung und den Datenempfang relevante Volumen des Untersuchungsobjekts während der Messung ändert, sich durch eine dynamische Optimierung der Kompensationseinstellungen für das aktuell relevante Volumen die Qualität der Daten signifikant verbessern lässt. Beispielsweise gilt dies für die zweidimensionale Mehrschicht-Bildgebung, bei Multi-Voxel-Spektroskopie (z.B. in Verbindung mit sukzessiver lokalisierter Anregung) oder bei Anwendung diverser Magnetisierungs-Präparationen (z.B. Fettunterdrückung, regionale Sättigung, Inversion, Markierungen etc.).

Die Aufgabe wird gelöst durch Verfahren zum Betrieb eines bildgebenden medizinischen Untersuchungsgeräts mit einer Mehrzahl an Teilsystemen und einer Steuereinrichtung, welche die Teilsysteme zur Durchführung einer Messsequenz koordiniert ansteuert, gemäß Anspruch 1, ein bildgebendes medizinisches Untersuchungsgerät gemäß Anspruch 10, ein Computerprogrammprodukt gemäß Anspruch 12 sowie einen elektronisch lesbaren Datenträger gemäß Anspruch 13.

Ein erfindungsgemäßes Verfahren zum Betrieb eines bildgebenden medizinischen Untersuchungsgeräts mit einer Mehrzahl an Teilsystemen und einer Steuereinrichtung, welche die Teilsysteme zur Durchführung einer Messsequenz koordiniert ansteuert, umfasst die Schritte:
- Übermitteln eines zu einer durchzuführenden Messung zugeordneten Steuerprotokolls an die Steuereinrichtung,
- Bestimmen von für das Steuerprotokoll relevanten Sequenzsteuerdaten, welche verschiedene funktionelle Teilsequenzen einer zu dem Steuerprotokoll gehörigen Messsequenz definieren,
- Zuordnen von unterschiedlichen Wirkvolumina zu jeder funktionellen Teilsequenz,
- Bestimmen von für die bestimmten relevanten Sequenzsteuerdaten und zugeordneten Wirkvolumina maßgeblichen, aktuellen Umgebungsbedingungen des bildgebenden medizinischen Untersuchungsgeräts,
- Berechnen und Speichern von Steuersignalen für die Messsequenz auf Basis der bestimmten Sequenzsteuerdaten, der Wirkvolumina und der bestimmten aktuellen Umgebungsbedingungen, derart dass die funktionellen Teilsequenzen der Messsequenz zumindest hinsichtlich eines Teilbereichs ihres zugeordneten Wirkvolumens lokal optimiert werden,
- Starten einer Messung gemäß dem Steuerprotokoll unter Verwendung der gespeicherten Steuersignale.

Durch das erfindungsgemäße Verfahren und seine zentrale Ermittlung von Steuersignalen noch vor Beginn der eigentlichen Messung wird es ermöglicht, eine dynamische Justierung und damit Optimierung von Steuersignalen zuverlässig, anwenderfreundlich und zeitoptimiert auch in der klinischen Routine einsetzen zu können. Dabei kann sich gezielt auf Teilbereiche in einem interessierenden Volumen des Untersuchungsobjekts beschränkt werden, was sich sowohl auf die Rechenzeiten als auch auf die Qualität der Untersuchungsergebnisse positiv auswirkt. Durch die Beschränkung auf jeweils relevante Sequenzsteuerdaten und die Bestimmung und Zurverfügungstellung der optimierten Steuersignale, wird der Datenfluss optimiert und lässt sich daher einfach in vorhandene Handlungsabläufe ("Workflows") integrieren. Durch die hierdurch verbesserten Anpassungsmöglichkeiten der Steuersignale ist es weiter möglich günstigere Hardware in den verwendeten bildgebenden medizinischen Untersuchungsgeräten zu verbauen, und diese damit kostengünstiger zu fertigen, da durch die Hardware ggf. suboptimale Umgebungsbedingungen mit dem Verfahren ausgeglichen werden können. Somit liegt mit dem erfindungsgemäßen Verfahren auch eine optimierte Integration der zu der Ermittlung der optimierten Steuersignale verwendeten Messungen, Auswertungen und Anwendungen in den technischen Ablauf der Messung der Daten des Untersuchungsobjekts über das Steuerprotokoll vor.

Hierbei ist es nicht wie bisher im Stand der Technik in der Regel erforderlich, dass ein Nutzer die Konsistenz verschiedener Messprotokolle, wie etwa Protokolle von Justierungsmessungen zur Bestimmung von Umgebungsbedingungen und von der eigentlichen Messung, sicherzustellen hat. Vielmehr können etablierte Justierungsmessungen verwendet werden, ohne dass ein Nutzer diese erst parametrisieren müsste.

Ein erfindungsgemäßes bildgebendes medizinisches Untersuchungsgerät mit einer Mehrzahl von Teilsystemen umfasst eine zur Durchführung eines erfindungsgemäßen Verfahrens ausgebildete Steuereinrichtung, wobei die Steuereinrichtung ausgebildet ist, um die Teilsysteme zur Durchführung einer Messsequenz auf Basis von Sequenzsteuerdaten koordiniert anzusteuern, wobei die Sequenzsteuerdaten verschiedene funktionelle Teilsequenzen der Messsequenz definieren, denen unterschiedliche Wirkvolumina zugeordnet sind.

Ein erfindungsgemäßes Computerprogramm implementiert ein erfindungsgemäßes Verfahren auf einer Steuereinrichtung, wenn es auf der Steuereinrichtung ausgeführt wird.

Ein erfindungsgemäßer elektronisch lesbarer Datenträger umfasst darauf gespeicherte elektronisch lesbare Steuerinformationen, welche zumindest ein erfindungsgemäßes Computerprogramm umfassen und derart ausgestaltet sind, dass sie bei Verwendung des Datenträgers in einer Steuereinrichtung eines bildgebenden medizinischen Untersuchungsgeräts ein erfindungsgemäßes Verfahren durchführen.

Die in Bezug auf das Verfahren angegebenen Vorteile und Ausführungen gelten analog auch für das bildgebende medizinische Untersuchungsgerät, das Computerprogrammprodukt und den elektronisch lesbaren Datenträger.

Weitere Vorteile und Einzelheiten der vorliegenden Erfindung ergeben sich aus den im Folgenden beschriebenen Ausführungsbeispielen sowie anhand der Zeichnungen. Die aufgeführten Beispiele stellen keine Beschränkung der Erfindung dar. Es zeigen:
- Fig. 1: eine schematische Darstellung eines Ausführungsbeispiels eines an sich bekannten bildgebenden medizinischen Untersuchungsgeräts in Form eines Magnetresonanzgeräts,
- Fig. 2: ein Ablaufdiagramm des erfindungsgemäßen Verfahrens,
- Fig. 3: ein sehr vereinfachtes Ausführungsbeispiel einer Messsequenz mit mehreren Teilsequenzen sowie deren zugeordneten Wirkvolumina mit einer Darstellung der für die erste Teilsequenz auf das erste Wirkvolumen optimierten Parameter für die einzelnen Teilsysteme,
- Fig. 4: die Messsequenz mit den einzelnen Teilsequenzen und zugeordneten Wirkvolumina wie in Figur 3, jedoch mit einer Darstellung der für die zweite Teilsequenz auf das zweite Wirkvolumen optimierten Parameter der Teilsysteme,
- Fig. 5: die Messsequenz mit den einzelnen Teilsequenzen und zugeordneten Wirkvolumina wie in Figur 3, jedoch mit einer Darstellung der für das dritte Wirkvolumen optimierten Parameter der Teilsysteme.

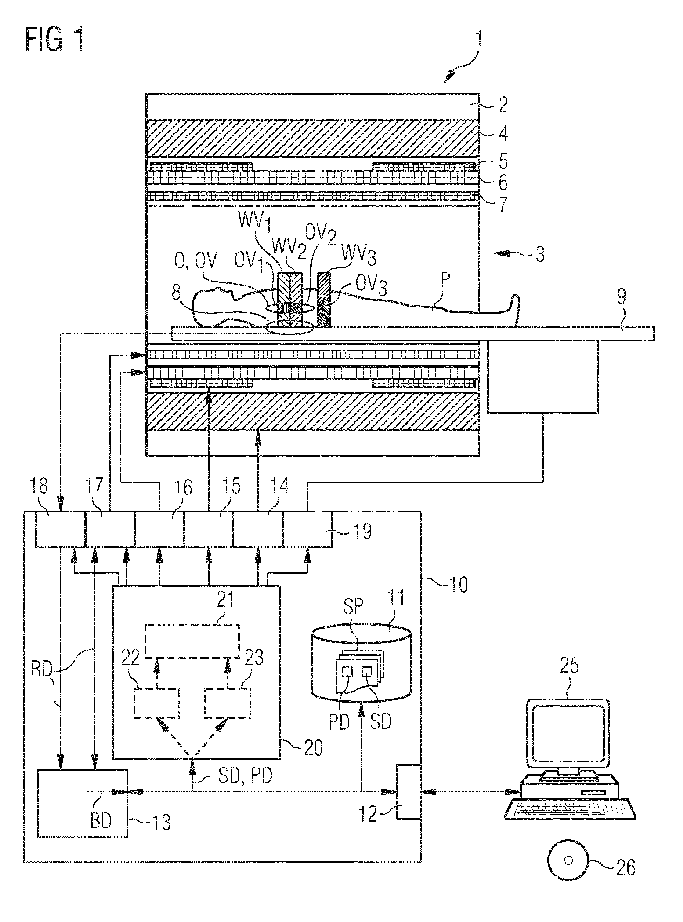

In Figur 1 ist grob schematisch ein bildgebendes medizinisches Untersuchungsgerät, hier in Form eines Magnetresonanzgeräts 1, dargestellt. Es umfasst zum einen den eigentlichen Magnetresonanzscanner 2 mit einem darin befindlichen Untersuchungsraum 3 bzw. Patiententunnel. Eine Liegeneinheit 9 ist in verschiedene Positionen in diesen Patiententunnel 3 hineinfahrbar, so dass ein darauf liegendes Untersuchungsobjekt, z.B. ein darauf liegender Patient P oder Proband, während einer Untersuchung an einer bestimmten Position innerhalb des Magnetresonanzscanners 2 relativ zu dem darin angeordneten Magnetsystem und Hochfrequenzsystem gelagert werden kann bzw. auch während einer Messung zwischen verschiedenen Positionen verfahrbar ist. Es wird an dieser Stelle darauf hingewiesen, dass die genaue Bauart des Magnetresonanzscanners 2 nicht wesentlich ist. So kann beispielsweise ein zylindrisches System mit einem typischen Patiententunnel genutzt werden, aber auch ein C-bogenförmiges Magnetresonanzgerät, welches an einer Seite offen ist.

Wesentliche Komponenten des Magnetresonanzscanners 2 sind ein Grundfeldmagnet 4, eine Anzahl von Shim-Spulen 5 und Magnetfeldgradientenspulen 6 sowie eine Ganzkörper-Hochfrequenzspule 7. Der Empfang von im Untersuchungsobjekt induzierten Magnetresonanzsignalen kann über die Ganzkörperspule 7 erfolgen, mit der in der Regel auch die Hochfrequenzsignale zur Induzierung der Magnetresonanzsignale ausgesendet werden. Es ist aber auch möglich, diese Signale beispielsweise mit auf oder unter den Patienten gelegten Lokalspulen 8 zu empfangen. Alle diese Komponenten sind dem Fachmann grundsätzlich bekannt und daher in der Figur 1 nur grob schematisch dargestellt.

Angesteuert werden die einzelnen Komponenten von einer Steuereinrichtung 10, die hier in Form eines gemeinsamen Blocks dargestellt ist. Hierbei kann es sich um einen Steuerrechner handeln, welcher auch aus einer Vielzahl von ggf. auch räumlich getrennten und über geeignete Kabel oder dergleichen untereinander verbundenen Einzelrechnern bestehen kann. Über eine Terminalschnittstelle 12 ist diese Steuereinrichtung 10 mit einem Terminal 25 verbunden, über das ein Bediener das gesamte Gerät 1 ansteuern kann. Unter Terminalschnittstelle 12 ist hierbei jede Verbindung, insbesondere von Eingabegeräten, wie etwa einer Maus und/oder Tastatur und von Anzeigegeräten wie etwa einem Bildschirm oder Monitor, des Terminals 25 mit der Steuereinrichtung 10 zu verstehen.

Diese Steuereinrichtung 10 weist u. a. eine Grundmagnetfeld-Steueranordnung 14, die beispielsweise die Kühlung der Grundfeldmagneten überwacht, eine Shim-Spulen-Steueranordnung 15 und eine Gradientenspulen-Steueranordnung 16 auf. Über eine Hochfrequenzsende-/-empfangseinheit 17 wird die Ganzkörperspule 7 angesteuert und ausgelesen. Der Hochfrequenzsendeteil der Hochfrequenzsende-/-empfangseinheit 17 umfasst zum Beispiel einen Hochfrequenzpulsverstärker zur Verstärkung und Formung der Hochfrequenzpulse und einen NCO, mit dem die Frequenz und Phasenlage der Hochfrequenzpulse festgelegt werden können. Über eine weitere Hochfrequenzempfangseinheit 18 werden eventuelle Lokalspulen 8 ausgelesen. Diese Hochfrequenzempfangseinheit 18 kann zum Beispiel eine Spulenauswahleinheit umfassen, um jeweils aus mehreren zur Verfügung stehenden Lokalspulen die passende Lokalspule auszuwählen, sowie einen NCO zur Festlegung der Frequenz und Phasenlage. Eine Patientenliegen-Steuereinheit 19 dient zum Ansteuern der Liegeneinheit 9.

Der Grundfeldmagnet 4 bildet gemeinsam mit seiner Steueranordnung 14 das Grundmagnetfeldsystem 4, 14, die Shim-Spulen 5 mit der zugehörigen Steueranordnung 15 das Shim-System 5, 15, die Magnetfeldgradientenspulen 6 mit der zugehörigen Steueranordnung 16 das Gradientensystem 6, 16, die Hochfrequenzspule 7 gemeinsam mit ihrer Hochfrequenzsende-/-empfangseinheit 17 ein Hochfrequenzsende-/-empfangssystem 7, 17 und die Lokalspulen 8 gemeinsam mit ihrer Hochfrequenzempfangseinheit 18 ein weiteres Hochfrequenzempfangssystem 8, 18.

Sämtliche Steueranordnungen 14, 15, 16, 19 bzw. die Hochfrequenzsende- und/oder -empfangseinheiten 17, 18 werden koordiniert von einer Zentralsteuereinheit 20 angesteuert, so dass die für die Durchführung einer Messung erforderlichen Grundmagnetfelder, Gradientenfelder und Hochfrequenzpulse synchronisiert ausgegeben werden, die Shim-Spulen richtig eingestellt werden und auch die Liegeneinheit 9 an der richtigen Position steht. Außerdem muss dafür gesorgt werden, dass zum passenden Zeitpunkt die Signale an den Lokalspulen 8 durch die Hochfrequenzempfangseinheit 18 bzw. eventuell Signale an der Ganzkörperspule 7 durch die Hochfrequenzsende-/- empfangseinheit 17 ausgelesen und entsprechend weiterverarbeitet werden.

Die so akquirierten Signale bzw. Rohdaten RD werden dann an eine Bildrekonstruktionseinheit 13 weitergegeben, in der die gewünschten Magnetresonanz-Bilddaten oder Spektroskopiedaten BD rekonstruiert werden, um sie dann beispielsweise auf dem Bildschirm des Terminals 25 auszugeben oder in einem Speicher 11 zu hinterlegen.

Es wird an dieser Stelle ausdrücklich darauf hingewiesen, dass ein solcher Magnetresonanzscanner 2 sowie die zugehörige Steuereinrichtung 10 noch eine Vielzahl weiterer Komponenten aufweisen oder aufweisen können, die hier nicht im Detail erläutert werden. Insbesondere kann beispielsweise das Untersuchungsgerät 1 auch über eine geeignete Schnittstelle mit einem Netzwerk, beispielsweise einem radiologischen Informationssystem (RIS), gekoppelt sein, um hierüber Steuerprotokolle zu empfangen, die an dem Gerät 1 genutzt werden können, oder um beispielsweise von dem Gerät 1 erzeugte Magnetresonanz-bilddaten zu versenden, in externen Massenspeichern zu hinterlegen oder an Befundungsstationen oder Drucker oder dergleichen zu übergeben.

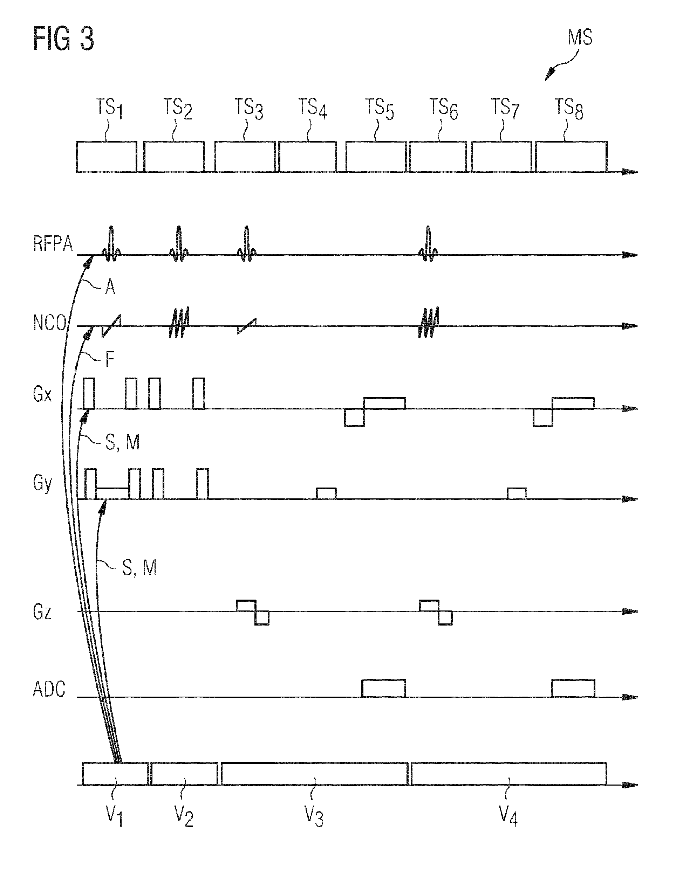

Die Generierung der Steuersignale für die einzelnen Steueranordnungen 14, 15, 16, 19 und die Hochfrequenzsende- und/oder -empfangseinheiten 18, 17 durch die Zentralsteuereinheit 20 erfolgt hier über ein in Form von Software auf einem Prozessor der Steuereinrichtung 10 realisiertes Steuersignal-Generierungsmodul 21, welches die Steuersignale ST auf Basis von Sequenzsteuerdaten SD generiert, die verschiedene Teilsequenzen der kompletten Messsequenz definieren. Ein Beispiel für eine solche aus mehreren Teilsequenzen bestehende Messsequenz wird später noch anhand der Figuren 3 bis 5 erläutert. Diese Sequenzsteuerdaten SD sind üblicherweise innerhalb von Steuerprotokollen SP festgelegt, die das Messprotokoll der durchzuführenden Messung charakterisieren und in einem Speicher 11 dem Gerät 1 hinterlegt sein können. Ein solches Steuerprotokoll SP enthält sämtliche Steuerdaten, die für den reibungslosen Ablauf einer bestimmten Messsequenz notwendig sind. Der Bediener kann beispielsweise über eine geeignete Benutzerschnittstelle mittels des Terminals 25 ein solches Steuerprotokoll SP für eine durchzuführende Messung auswählen und dann die Messung anhand dieses Steuerprotokolls SP vollautomatisch durchführen lassen. Es ist aber auch möglich, dass der Bediener ein Steuerprotokoll SP aufruft und modifiziert, um beispielsweise spezielle Messungen durchzuführen. Ebenso ist es auch möglich, Steuerprotokolle SP über eine weitere (nicht dargestellte) Netzschnittstelle auf anderen Rechnern, insbesondere vom Hersteller der Magnetresonanzanlage oder von speziellen, sich mit der Entwicklung von Steuerprotokollen befassenden Dienstleistern zur Verfügung gestellten Steuerprotokollen, auszuwählen.

Wie oben bereits ausführlich erläutert, ist es für die Erzielung einer möglichst guten Bildqualität sinnvoll, wenn die einzelnen Teilsysteme für eine bestimmte Teilsequenz so angesteuert werden, dass sie auf das für die bestimmte Teilsequenz wesentliche Wirkvolumen oder einen bestimmten Teil davon optimiert werden. Dies erfolgt bisher dadurch, dass der Entwickler eines Steuerprotokolls bereits vorab berücksichtigt, welches Wirkvolumen für welche Teilsequenz relevant ist und dann entsprechend die Sequenzsteuerdaten bzw. die Parameter für die Teilsysteme im Steuerprotokoll modifiziert, so dass mit der Teilsequenz eine Optimierung im definierten Wirkvolumen erreicht wird.

Das hierin beschriebene Verfahren kann auch in Form eines Computerprogramms vorliegen, das das Verfahren auf einer Steuereinrichtung 10 implementiert, wenn es auf der Steuereinrichtung 10 ausgeführt wird. Ebenso kann ein elektronisch lesbarer Datenträger 26 mit darauf gespeicherten elektronisch lesbaren Steuerinformationen vorliegen, welche zumindest ein beschriebenes Computerprogramm umfassen und derart ausgestaltet sind, dass sie bei Verwendung des Datenträgers 26 in einer Steuereinrichtung 10 eines bildgebenden medizinischen Untersuchungsgeräts 1 ein beschriebenes Verfahren durchführen.

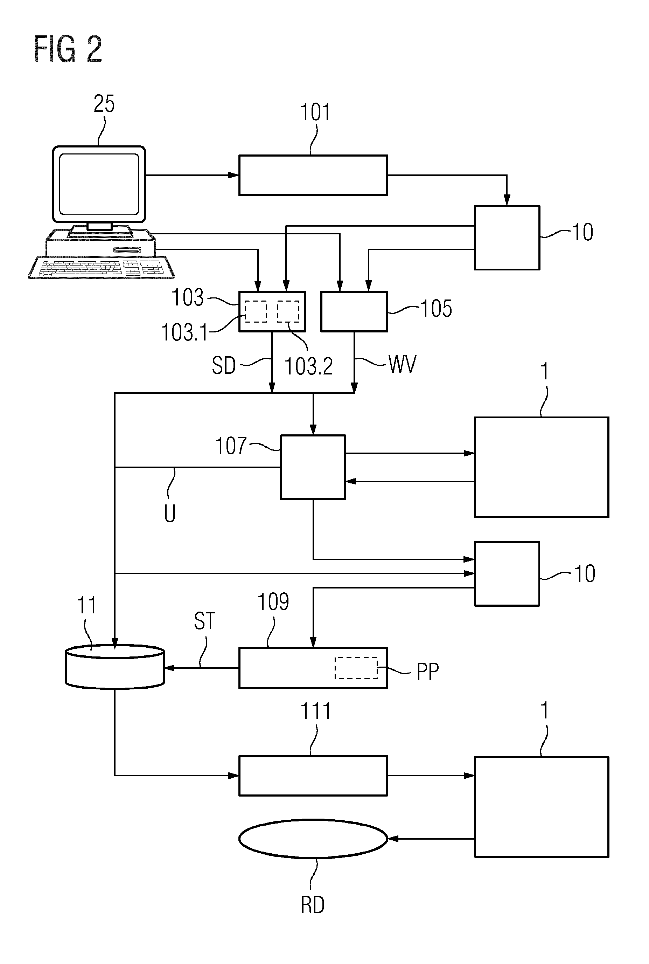

In Figur 2 ist der Ablauf eines erfindungsgemäßen Verfahrens zum Betrieb eines bildgebenden medizinischen Untersuchungsgeräts mit einer Mehrzahl an Teilsystemen und einer Steuereinrichtung 10, welche die Teilsysteme zur Durchführung einer Messsequenz koordiniert ansteuert, dargestellt.

Hierbei wird vor Beginn einer durchzuführenden Messung an einem Patienten P oder sonstigen Untersuchungsobjekt zunächst in einem Schritt 101 das zu einer durchzuführenden Messung zugeordnete Steuerprotokoll an die Steuereinrichtung 10 des bildgebenden medizinischen Untersuchungsgeräts 1 übermittelt. Dazu können von einem Benutzer an dem Terminal 25 des bildgebenden medizinischen Untersuchungsgeräts 1 Eingaben gemacht werden, z.B. ein bestimmtes Steuerprotokoll ausgewählt und/oder auch nach den aktuellen Wünschen abgeändert werden wie bereits oben beschrieben wurde.

In einem weiteren Schritt 103 werden die für das übermittelte Steuerprotokoll relevanten Sequenzsteuerdaten SD, welche verschiedene funktionelle Teilsequenzen einer zu dem Steuerprotokoll gehörigen Messsequenz definieren, bestimmt und im Speicher 11 gespeichert. Hierbei können je nach Typ der gewünschten Messung, welche z.B. den Sequenztyp, weitere MessParameter und eine zu untersuchende Körperregion, kurz das Steuerprotokoll, vorgibt, für eine unterschiedliche Auswahl an Sequenzsteuerdaten z.B. eine dynamische Anpassung sinnvoll sein. Beispielsweise, wenn eine Messung relativ unempfindlich gegenüber Variationen des B₁-Feldes sein sollte, können zur Vereinfachung des Ablaufs der anschließenden Messung die entsprechenden Sequenzsteuerdaten SD, wie etwa eine Transmitter-Skalierung für die Flipwinkeleinstellung oder auch B₁-Shimeinstellungen, als statisch einzustellende Sequenzsteuerdaten SD (Schritt 103.1) eingeteilt werden, während andere Sequenzsteuerdaten, welche beispielsweise das B₀-Feld betreffen, als dynamisch anzupassende Sequenzsteuerdaten SD (Schritt 103.2) eingeteilt werden. Auf diese Weise kann die Robustheit des Verfahrens verbessert werden und der Umfang an durchzuführenden Messungen zur Bestimmung der Umgebungsbedingungen reduziert werden.

Weiterhin werden in Schritt 105 unterschiedlichen Wirkvolumina WV zu jeder funktionellen Teilsequenz zugeordnet und gespeichert. Dies kann insbesondere automatisch anhand des Steuerprotokolls erfolgen. Z.B. kann bei einer gewünschten Mehrschicht-Messung jede aufzunehmende Schicht ein solches Volumen definieren. Ein anderes Beispiel wäre ein durch das Steuerprotokoll vorgegebenes regionales Sättigungsvolumen. So kann bereits unmittelbar nach Festlegung des Steuerprotokolls eine Liste aller während des Messablaufs jeweils relevanter Wirkvolumina WV erstellt und gespeichert werden. Hierzu wird später mit Bezug auf die Figuren 3 bis 5 weiter ausgeführt.

Weiterhin ist es hierbei möglich, dass Änderungen oder Ergänzungen einer solchen Liste an Wirkvolumina WV automatisch aufgrund der über das Steuerprotokoll ausgewählten Bildgebungssequenz erfolgen. Dies ist insbesondere in Fällen denkbar, wenn aus Gründen der MR-Physik, z.B. zur Vermeidung von Artefakten wie z.B. dem sogenannten "Inflow" bei Verwendung von Magnetisierungs-Inversionstechniken oder bei "Chemical Shift-Artefakten" bei regionaler Sättigung, derartige Korrekturen der vom Benutzer angegebenen Parameter in Form des Steuerprotokolls notwendig sind. Hierbei ist auch denkbar, dass die durch das Steuerprotokoll gewählte Messsequenz intern, d.h. ohne einen zugehörigen durch einen Nutzer manipulierbaren Parameter, weitere Volumina für spezielle Manipulationen des Spinsystems benötigt und diese daher als Wirkvolumina WV erfasst werden.

Darüber hinaus kann eine direkte oder auch nur eine indirekte Manipulation an Optimierungsvolumina durch den Nutzer vorgesehen sein. Beispielsweise kann der Nutzer ein Volumen als Optimierungsvolumen (z.B. "Volume of Interest") vorgeben, das z.B. den interessierenden anatomischen Bereich einschließt. Die jeweiligen Wirkvolumina WV können dann jeweils auf den Teilbereich der Schnittmenge ihrer selbst mit dem geltenden Optimierungsvolumen eingeschränkt werden. Somit erlaubt das erfindungsgemäße Verfahren eine Optimierung für beliebige Teilbereiche der Wirkvolumen und ist nicht auf z.B. die durch die Messung vorgegebenen Wirkvolumen, wie etwa die Schichten bei Mehrschicht-Messungen, beschränkt.

In Schritt 107 werden die aktuellen, für die bestimmten relevanten Sequenzsteuerdaten SD und zugeordneten Wirkvolumina WV maßgeblichen Umgebungsbedingungen U des bildgebenden medizinischen Untersuchungsgeräts 1 bestimmt. Hierbei kann auf die zugeordneten Wirkvolumina WV und die bestimmten, erforderlichen Steuersequenzdaten SD und insbesondere deren Einteilung in statisch aufzunehmende 103.1 und dynamisch anzupassende Sequenzsteuerdaten 103.2 zurückgegriffen werden. Die Einteilung der bestimmten Sequenzsteuerdaten SD legt fest, für welche physikalischen Umgebungsbedingungen U ein globaler Wert genügt (bei statisch anzuwendenden Sequenzsteuerdaten), und wann lokale Werte für die Umgebungsbedingungen U erforderlich sind (bei dynamisch anzupassenden Sequenzsteuerdaten). Für globale Werte ist in der Regel eine schnell durchführbare Justierungsmessung mit dem bildgebenden medizinischen Untersuchungsgerät 1 ausreichend. Für lokale Werte sind unter Umständen umfangreichere Justierungsmessungen erforderlich. Beispielsweise können lokale Werte der Umgebungsbedingungen U durch sukzessive Justierungsmessungen für jedes relevante Wirkvolumen WV bzw. den relevanten Teilbereich des Wirkvolumens bestimmt werden. Diese Vorgehensweise stellt eine einfache und etablierte Methode dar, ist jedoch zeitaufwendig und muss bei Änderungen der Sequenzsteuerdaten wiederholt werden. Durch die Beschränkung auf Justierungsmessungen nur für die bei dem jeweiligen Steuerprotokoll relevanten Sequenzsteuerdaten werden die Zahl der durchzuführenden Justierungsmessungen und damit der Aufwand jedoch wieder beschränkt. Alternativ können, in einem z.B. einmaligen Aufwand, Karten der physikalischen Umgebungsbedingungen U aufgenommen werden, die dann als Datenbasis für beliebige Sequenzsteuerdaten SD dienen können. Beispielsweise können hierzu Karten der B0-Feldverteilung und/oder Karten der B1-Feldverteilung, letztere ggf. für mehrere oder sogar alle Elemente eines mehrere Sende-Elemente umfassenden Sendesystems, aufgenommen werden. Hierbei können in beiden Fällen etablierte Justierungsmessungen verwendet werden. Liegen bereits Umgebungsbedingungs-Daten für relevante Wirkvolumina WV oder relevante Teilbereiche der Wirkvolumina aus früheren Justierungsmessungen vor, können diese ohne erneute Justierungsmessung wiederverwendet werden. Somit sind einmalig aufgenommene Justierungsdaten, wie etwa bereits ermittelte Umgebungsbedingungen für bestimmte relevante Wirkvolumina WV oder relevante Teilbereiche der Wirkvolumina für mehrere Messungen verwendbar.

In der Steuereinheit 10 werden in Schritt 109 Steuersignale ST für die Messsequenz auf Basis der bestimmten Sequenzsteuerdaten SD, der zugeordneten Wirkvolumina WV und der maßgeblichen, bestimmten aktuellen Umgebungsbedingungen U berechnet und in Speicher 11 gespeichert. Die Berechnung erfolgt hierbei derart, dass die funktionellen Teilsequenzen der Messsequenz zumindest hinsichtlich eines Teilbereichs ihres zugeordneten Wirkvolumens WV, beispielsweise des Schnittbereichs des jeweiligen Wirkvolumens mit einem Optimierungsvolumen, lokal optimiert werden.

Bei der Berechnung der Steuersignale ST kann weiterhin eine Plausibilitätsprüfung PP umfasst sein, um etwaige Mängel bereits hier an zentraler Stelle feststellen und damit abfangen zu können. Beispielsweise kann die Plausibilitätsprüfung PP für verschiedene Wirkvolumen WV berechnete Steuersignale ST zueinander in Bezug setzten. Hierbei können insbesondere Wechselwirkungen zwischen verschiedenen Sequenzsteuerdaten, wie z.B. zwischen Gradienten-Nichtlinearitäten, HF-Mittenfrequenzen und Shim-Strömen, berücksichtigt werden. Insbesondere, da die Berechnung der Steuersignale ST für die gesamte Messung vor Start der Messung unter Kenntnis des Messprotokolls durchgeführt wird, können hier auch Mittelwerte, insgesamte SAR-Werte und Stimulationspotentiale betrachtet werden.

Es können aber auch, zusätzlich oder alternativ, die berechneten Steuersignale ST für verschiedene Wirkvolumen WV oder deren gewünschte Teilbereiche zueinander in Bezug gesetzt werden, um möglicherweise fehlerhaft berechnete Steuersignale korrigieren zu können. Hierzu kann beispielsweise berücksichtigt werden, dass reale physikalische Umgebungsbedingungen in der Regel nur eine moderate räumliche Variationen aufweisen und dies somit auch für die optimierten berechneten Steuersignale gelten sollte. Ist dies nicht der Fall könnte dies an einer mangelnden Qualität der zugehörigen der Berechnung zugrunde liegenden gemessenen Umgebungsbedingungs-Daten liegen. Derartige auf einer mangelhafte Grundlage berechneten Steuersignale ST können bei der Plausibilitätsprüfung PP entdeckt und beispielsweise durch aus den korrespondierenden Steuersignalen ST benachbarter Wirkvolumen WV interpolierte, korrigierte Steuersignale ersetzt werden.

Weiterhin oder alternativ kann die Plausibilitätsprüfung PP einzuhaltende Schwellwerte für die Sequenzsteuerdaten SD umfassen, die beispielsweise sicherstellen, dass von dem bildgebenden medizinischen Untersuchungsgerät 1 z.B. aus technischen Gründen vorgegebene Grenzen für die jeweiligen Sequenzsteuerdaten SD, wie etwa Gradientenströme (maximal oder im Mittel zulässiger Strom auf den Gradientenspulen) und damit Slew-Rates oder Shimströme erster Ordnung (im Mittel zulässiger Offset-Strom auf den Gradientenspulen) und Shimströme höherer Ordnung (im Mittel zulässiger Strom auf den Shim-Spulen), maximale Offset-Frequenzen des HF-Sende- und - Empfangssystems z.B. für die HF-Mittenfrequenzen etc., nicht überschritten werden.

Neben derartigen systembedingten Schwellwerten können auch sicherheitsbedingte Schwellwerte vorgesehen sein, die beispielsweise die durch die Messung applizierte SAR-Belastung beschränken wie etwa eine maximale oder im Mittel zulässige HF-Sendeleistung insbesondere bei Mehrkanal-Sendesystemen.

Weiterhin oder auch alternativ können qualitätsbezogene Schwellwerte vorgesehen sein, die beispielsweise sicherstellen, dass ein Steuersignal durch die Optimierung nicht in qualitätsbeeinträchtigender Weise von dem ursprünglich in dem Steuerprotokoll vorgegebenen Werten abweicht. Beispielsweise könnte eine durch die Optimierung fehlerhaft stark von der ursprünglich vorgesehenen HF-Mittenfrequenz abweichende HF-Mittenfrequenz dazu führen, dass die gemessene Schicht bzw. der gemessene Ausschnitt in dem Untersuchungsobjekt verschoben wird und dass damit nicht der gewünschte Bereich in dem Untersuchungsobjekt gemessen (z.B. eine andere oder verschobene Anatomie eines Patienten P abgebildet) wird.

Bei einer Messung mit ausschließlich statischer Anpassung der verwendeten Sequenz, bei dem daher nur ein Wirkvolumen vorliegt, in welchem die Teilsequenzen optimiert werden, bleibt in der Regel hinreichend Zeit für eine intensive Prüfung der Resultate, sodass bei verschobenen Messungen ggf. erneut mit korrigierten Werten gemessen werden kann.

Bei Messungen mit dynamischen Anpassungen der Sequenzsteuerdaten mit ihrer Vielzahl an Wirkvolumen wäre eine derartige erneute Messung für alle Wirkvolumen zeitlich meist zu aufwendig. Um dies daher zu vermeiden können als qualitätsbezogene Schwellwerte beispielsweise maximale Abweichungen des durch die Optimierung geänderten, in dem Steuersignal enthaltenen Wertes betroffener Sequenzsteuerdaten von dem ursprünglich in dem Steuerprotokoll vorgesehenen Wert angegeben sein.

Oder es kann als qualitätsbezogener Schwellwert eine maximale zulässige Abweichung des erfindungsgemäß dynamisch berechneten Parameters von einem korrespondierenden statischen Parameter definiert sein. Hierbei könnte z.B. die dynamische Variation der HF-Mittenfrequenz auf relativ zu der Größe des zu messenden Bereichs des Untersuchungsobjekts geringe Verschiebungen des Messvolumens von beispielsweise unter zehn Prozent, insbesondere unter fünf Prozent, der Größe des zu messenden Bereichs des Untersuchungsobjekts beschränkt sein. Hierbei kann die Schwelle für die Verschiebung durch die Variation der HF-Mittenfrequenz auch in Pixeln, beispielsweise "maximal zehn Pixel" oder in einer Längeneinheit, beispielsweise "maximal fünf Millimeter" angegeben sein.

Denkbar wäre somit beispielsweise eine Übermittlung aller dynamisch einzustellenden Sequenzsteuerdaten aus Schritt 103, der zugeordneten Wirkvolumen aus Schritt 105 und der bestimmten Umgebungsbedingungen aus Schritt 107 an die Steuereinheit 10, die unter Kenntnis der zu der ausgewählten Messung gehörenden Messsequenz in Schritt 109 die Systemsteuerdaten bestimmt. Dabei kann beispielsweise die zeitliche Abfolge von zu schaltenden Gradientenpulsen, unter Berücksichtigung Volumen-spezifischer Shim-Offsetströme in der Plausibilitätsprüfung PP, und/oder die zeitliche Abfolge von HF-Pulsen, unter Berücksichtigung Volumen-spezifischer Transmitter-Skalierungsfaktoren und/oder HF-Leistungsverteilungen des HF-Sendesystems in der Plausibilitätsprüfung PP, berechnet werden. Hierbei kann bereits eine Berechnung für einen repräsentativen Abschnitt, z.B. eine Wiederholung der Messsequenz, genügen. Aus der zeitlichen Abfolge der so berechneten Hardware-Ansteuer-Sequenzsteuerdaten können dann die Mittelwerte der relevanten Größen ermittelt werden, z.B. die durch die Gradientenströme verursachte mittlere thermische Last oder die mittlere HF-Leistung. Aus der zeitlichen Abfolge von HFspezifischen Sequenzsteuerdaten lässt sich der prognostizierte Energieeintrag in das Untersuchungsobjekt ermitteln, ggf. unter Verwendung bekannter Modelle. Aus der zeitlichen Abfolge von Gradienten-spezifischen Sequenzsteuerdaten lässt sich das prognostizierte Stimulationspotential, unter Verwendung bekannter Modelle, berechnen. Bei Messungen mit physiologischer Triggerung können hierbei auch zumindest Schätzwerte, z.B. für ein Schlimmstfallszenario ermittelt werden. Neben einfachen Mittelwerten können auch komplexere Größen, wie beispielsweise Kontenmodelle wie sie in der DE 10 2007 036564 B4 beschrieben sind, betrachtet werden.

Wird bei der Plausibilitätsprüfung PP eine Überschreitung eines derartigen qualitätsbezogenen Schwellwerts festgestellt, kann beispielsweise als korrigierter Wert entweder der qualitätsbezogene Schwellwert selbst oder auch der statischen Wert angewendet werden oder es können Messpausen in die Messsequenz eingeführt werden, die z.B. die Wiederholzeit TR verlängern und so die von dem überschrittenen Schwellwert betroffenen Größen z.B. reduzieren. Weiterhin ist es denkbar, die zu erreichenden Flipwinkel zu reduzieren und/oder die HF-Pulstypen zu ändern (z.B. durch Verlängerung der HF-Pulsdauer oder Verwendung von sogenannten "Low-SAR"- bzw. Verse-Pulsen), um beispielsweise SAR-relevante Größen zu reduzieren und auf diese Weise wieder innerhalb den, durch den entsprechenden Schwellwert vorgegebenen, Grenzbereich zu gelangen. Ebenso kann beispielsweise die minimale Gradienten-Anstiegszeit erhöht oder der gewählte Bildausschnitt (FOV) vergrößert oder die Matrixgröße der Messung reduziert werden, um die Werte von Stimulationsgrenzen-relevanten Sequenzsteuerdaten zu reduzieren und wieder innerhalb die, durch die jeweiligen Schwellwerte vorgegebenen, Grenzen zu bringen.

Anstelle einer direkten Verwendung des statischen Werts eines solchen zu korrigierenden Werts kann auch der betreffende erechnete Wert z.B. schrittweise dem statischen Wert angenähert werden, bis er sich innerhalb der durch den zugehörigen Schwellwert gesetzten Grenzen befindet. Zusätzlich oder alternativ kann auch der Benutzer über das Terminal 25 über die Überschreitung des qualitätsbezogenen Schwellwerts und ggf. über deshalb vorgenommene Änderungen informiert werden. In SAR-bezogenen Fällen kann hierbei auch, nach Bestätigung durch den Nutzer, ein Wechsel in einen anderen SAR-Kontrollmodus bzw. Stimulations-Kontrollmodus vorgenommen werden. Damit wird die Reaktion auf derartige Überschreitungen von Grenzwerten für einen Nutzer nachvollziehbar. Die genannten Arten von Schwellwerten können für verschiedene Systemsteuerdaten beliebig kombiniert werden.

Über derartige Schwellwerte kann durch das Verfahren somit vorteilhaft auch auf system- oder subjekt-bedingte Limitierungen eingegangen werden. Somit werden effektiv Messabbrüche bei der auf die Berechnung der Sequenzsteuerdaten folgenden Messung vermieden, da es nicht zu Überschreitungen technischer oder physiologischer Grenzen kommen kann, wobei gleichzeitig die Leistungsfähigkeit des bildgebenden medizinischen Untersuchungsgeräts optimal ausgenutzt werden kann.

Wird bei der Plausibilitätsprüfung PP irgend ein Mangel der berechneten Steuersignale ST festgestellt, kann beispielsweise der Nutzer über das Terminal 25 verständigt werden und ggf. Alternativlösungen angeboten und/oder ausgewählt werden. Werden berechnete Sequenzsteuerdaten bei der Plausibilitätsprüfung PP korrigiert, wird der korrigierte Wert im Speicher 11 gespeichert.

Bei alledem kann die Zentralsteuereinheit 20 der Steuereinheit 10 beispielsweise neben einem Steuersignal-Generierungsmodul 21 ein Sequenzsteuerdaten-Ermittlungsmodul 22 aufweisen, welches innerhalb eines Steuerprotokolls SP die Sequenzsteuerdaten SD erkennt und ausliest. Zusätzlich weist die Zentralsteuereinheit 20 bevorzugt ein Positionsdaten-Ermittlungsmodul 23 auf, welches die Wirkvolumen-Positionsdaten PD im Steuerprotokoll SP erkennt, und die so gewonnenen Sequenzsteuerdaten und Positionsdaten werden dann vom Steuersignal-Generierungsmodul 21 in geeigneter Weise verarbeitet, um die gewünschte Optimierung zu erreichen. Prinzipiell können das Sequenzsteuerdaten-Ermittlungsmodul 22 sowie das Positionsdaten-Ermittlungsmodul 23 auch als kombiniertes Modul realisiert sein, welches die Sequenzsteuerdaten SD und die Wirkvolumen-Positionsdaten PD erkennt und an das Steuersignal-Generierungsmodul 21 übergibt. Des Weiteren können das Sequenzsteuerdaten-Ermittlungsmodul und das Positionsdaten-Ermittlungsmodul auch in das Steuersignal-Generierungsmodul 21 integriert sein. In Figur 1 wurde jedoch eine separate Darstellung dieser Module gewählt, um klarzustellen, dass erst in der Zentralsteuereinheit 20 die Optimierung auf die den einzelnen Teilsequenzen der Messsequenz zugeordneten Wirkvolumina vollautomatisch erfolgt.

Insbesondere kann die Positionsdaten-Ermittlungseinrichtung 23 auch so ausgebildet sein, dass sie beispielsweise auf Basis von erhaltenen Wirkvolumen-Positionsdaten PD und auf Basis von mit Hilfe der Rekonstruktionseinheit 13 in vorherigen Übersichtsmessungen erzeugten Bilddaten BD ein eingeschränktes Optimierungsvolumen für einzelne Teilsequenzen bestimmt.

Ein Beispiel, wann dies sinnvoll ist, ist ebenfalls in Figur 1 schematisch an dem Patienten P im Patiententunnel 3 dargestellt. Gezeigt sind hier drei verschiedene Schichten, für die bestimmte Teilsequenzen innerhalb einer Messsequenz durchgeführt werden sollen. Jede dieser Schichten weist ein ganz bestimmtes Wirkvolumen WV₁, WV₂, WV₃ auf, wobei aber nur ein Teil dieses Volumens tatsächlich einen Teil des zu untersuchenden Patienten P umfasst. Bereiche in diesem Wirkvolumen WV₁, WV₂, WV₃ außerhalb des Patientenkörpers tragen keinerlei wesentliche Bildinformationen. Daher ist es sinnvoll, als Optimierungsvolumen nur den Teilbereich des Wirkvolumens WV₁, WV₂, WV₃ zu nutzen, welcher sich mit dem Körper des Patienten P überdeckt. Bei der dritten Schicht WV₃ ist dieses Optimierungsvolumen OV₃ der gesamte Bereich, der sich als Schnittmenge zwischen dem Wirkvolumen WV₃ und dem Volumen des Patientenkörpers ergibt.

Anhand der anderen beiden Wirkvolumina WV₁, WV₂ ist eine weitere Variante dargestellt. Hier wird davon ausgegangen, dass innerhalb des Körpers des Patienten P ein bestimmtes Organ O als Untersuchungsobjekt O untersucht werden soll. Dieses Organ O hat ein bestimmtes Objektvolumen OV. Da nur dieses Volumen OV interessant ist, wird hier die Schnittmenge aus dem Objektvolumen OV mit den Wirkvolumina WV₁, WV₂ gebildet, um die jeweiligen Optimierungsvolumen OV₁, OV₂ zu finden. Sollte der Fall eintreten, dass ein Wirkvolumen keine Schnittmenge mit einem zugehörigen Optimierungsvolumen aufweist, kann beispielsweise auf die Bildung der Schnittmenge verzichtet werden, und nur das Wirkvolumen betrachtet werden oder es kann das Optimierungsvolumen für das zugehörige, keine Schnittmenge mit dem Optimierungsvolumen aufweisende, Wirkvolumen als zugrunde zu legendes neues Optimierungsvolumen extrapoliert werden. Ein solcher Fall könnte beispielsweise dann eintreten, wenn die für die Messung vorgesehenen zu messenden Schichten größer sind als das vom Benutzer festgelegte VOI oder größer als das abzubildende Organ.

Wird nun die eigentliche Messung gemäß dem Steuerprotokoll gestartet (Schritt 111), greift die Steuereinheit 10 auf die gespeicherten Steuersignale ST für die Messung zurück. Hierbei wird z.B. jeweils ein zu einem aktuellen Wirkvolumen der laufenden Messung gehörendes, ggf. nach der Plausibilitätsprüfung PP geändertes, gespeichertes Steuersignal ST von dem Speicher 11 geladen und zur Steuerung der Messung verwendet. Es ist auch denkbar, dass die gespeicherten Steuersignale ST nicht direkt verwendet werden, sondern nur als Basis für die verwendeten Steuersignale dienen.

Beispielsweise kann im Verlauf der Messung stets das aktuelle Wirkvolumen der Messsequenz ermittelt werden. Zu dem ermittelten aktuellen Wirkvolumen kann dann aus den gespeicherten Steuersignalen ein anzuwendendes Steuersignal ermittelt werden. Hierbei ist es insbesondere denkbar, dass die tatsächlich verwendeten Steuersignale auf Basis der gespeicherten Steuersignale und der zugehörig gespeicherten Wirkvolumina und Umgebungsbedingungen entsprechend der während der Messung vorliegenden Wirkvolumina und/oder Umgebungsbedingungen interpoliert werden.

Die Steuersignale steuern das bildgebende medizinische Untersuchungsgerät 1, welches dadurch Rohdaten RD erzeugt, die wiederum im Speicher 11 gespeichert oder als Bilddaten oder Spektroskopiedaten rekonstruiert und ggf. angezeigt werden können.

Unter Bezug auf die Figuren 3 bis 5 werden noch einmal anhand einer konkreten, aber sehr vereinfachten Messsequenz MS die Möglichkeiten der Optimierung der einzelnen Teilsysteme auf ein einer bestimmten Teilsequenz zugeordnetes Wirkvolumen erläutert.

In der obersten Zeile sind dabei jeweils in Form von einzelnen Blöcken verschiedene Teilsequenzen TS₁, TS₂, ..., TS₈ benannt. In der untersten Spalte sind die diesen Teilsequenzen TS₁, TS₂, ..., TS₈ der Messsequenz MS zugeordneten Wirkvolumina V₁, V₂, V₃, V₄ dargestellt.

Daraus ist zu ersehen, dass der ersten Teilsequenz TS₁ ein erstes Wirkvolumen V₁ und der zweiten Teilsequenz TS₂ ein zweites Wirkvolumen V₂ zugeordnet ist. Den Teilsequenzen TS₃, TS₄, TS₅ ist ein gemeinsames Wirkvolumen V₃ zugeordnet. Ebenso ist den Teilsequenzen TS₆, TS₇, TS₈ ein Wirkvolumen V₄ zugeordnet.

Zwischen der unteren und der oberen Zeile sind jeweils auf separaten Zeitstrahlen für die einzelnen Teilsequenzen die von den Teilsystemen auszugebenden Pulse separat dargestellt. D. h. durch das synchrone Ausgeben der jeweils unterhalb der durch die Blöcke markierten Teilsequenzen TS₁, TS₂, ..., TS₈ dargestellten Pulse bzw. Einstellung der entsprechenden Parameter an den Teilsystemen werden die einzelnen Teilsequenzen TS₁, TS₂, ..., TS₈ durchgeführt. In der zweitobersten Zeile sind die vom Hochfrequenzpulsverstärker RFPA auszugebenden Hochfrequenzpulsformen und -Amplituden symbolisch dargestellt. In der zweiten Zeile ist die jeweils einzustellende NCO-Phase symbolisiert, wobei die Steigung der Kurve die Frequenzhöhe symbolisiert. In den nachfolgenden Zeilen sind die Gradientenpulse Gx, Gy, Gz eingezeichnet und in der vorletzten Zeile das Auslesefenster, in dem ein Analog/Digitalwandler ADC zum Auslesen einer ausgewählten Empfangsspule angesteuert wird. Der Einfachheit halber ist hier ein Einkanal-Sendesystem dargestellt. Bei Mehrkanal-Sendesystemen könnte beispielsweise für jedes Sendeelement der HF-Pulsverlauf (Amplitude und / oder Phase) unterschiedlich aussehen, um den B1-Shim zu realisieren

Die erste Teilsequenz TS₁ der Messsequenz MS dient hier zu einer regionalen Sättigung, d. h. es werden sämtliche Kerne innerhalb eines regional begrenzten Wirkvolumens V₁ gesättigt. Hierzu werden zunächst zur Dephasierung kurze, intensive Gx- und Gy-Gradienten geschaltet. Anschließend wird ein Hochfrequenzpuls einer bestimmten Form und Amplitude mit einem bestimmten vom NCO ausgegebenen zeitlich variablen Phasenverlauf ausgesendet, dessen Anstieg der Frequenz des Hochfrequenzpulses entspricht, während gleichzeitig zur Schichtselektion ein weiterer Gy-Gradientenpuls gesendet wird. Diese Teilsequenz schließt mit einem weiteren kurzen, intensiven Gradientenpuls in x- und y-Richtung zur Dephasierung ab.

Hinsichtlich des Wirkvolumens V₁ können von der Steuereinrichtung - da dieses Wirkvolumen V₁ bekannt ist - automatisch verschiedene Parameter optimiert werden. Zum einen kann die Amplitude A des auszusendenden Hochfrequenzpulses und gleichzeitig auch die Frequenz F, die vom NCO ausgegeben wird, optimiert werden. Außerdem können beispielsweise die Shim-Offsetströme S für die Gradientenspulen Gx, Gy passend eingestellt werden und es können hier auch gleich passende Parameter für eine Maxwell-Korrektur M übergeben werden. Die abhängig vom jeweiligen Wirkvolumen V₁ lokal optimierten Parameter sind in Figur 3 als von der unteren Zeile vom ersten Volumen V₁ ausgehende Pfeile dargestellt.

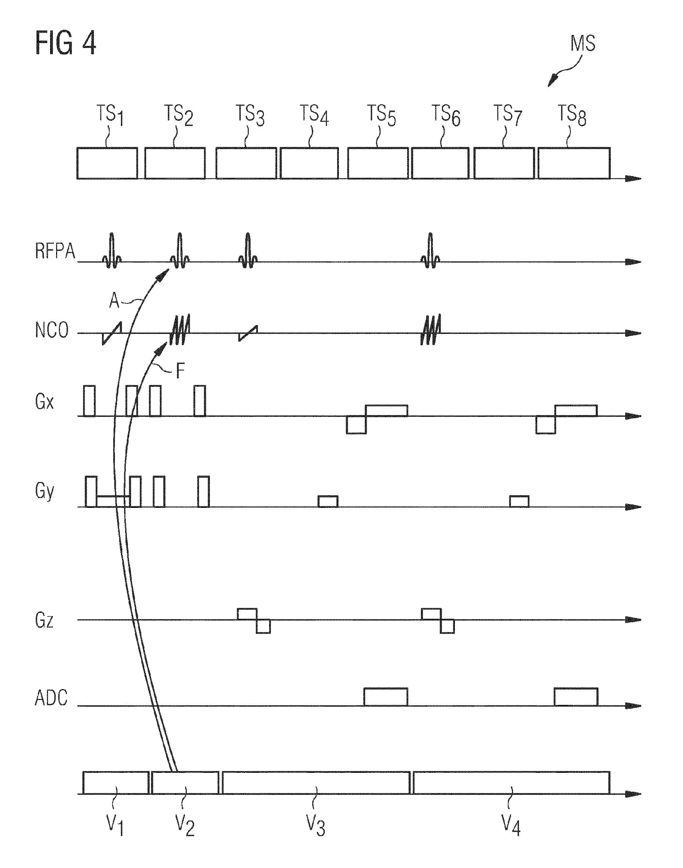

Eine weitere Teilsequenz TS₂, welche sich der ersten Teilsequenz TS₁ unmittelbar anschließt, ist eine chemische Sättigung, beispielsweise eine Fettsättigung. Diese erfolgt sehr ähnlich wie die regionale Sättigung durch Aussenden eines Hochfrequenzpulses mit einer bestimmten Amplitude und einer durch den NCO vorgegebenen Frequenz, wobei hier die Frequenz höher ist als bei der regionalen Sättigung in der Teilsequenz TS₁. Auch werden hier vor Aussenden des Hochfrequenzpulses und nach dem Aussenden des Hochfrequenzpulses jeweils nur die Dephasierungspulse im Gx- und Gy-Gradient geschaltet. Die Aussendung eines Gy-Gradienten zur Schichtselektion (wie in der ersten Teilsequenz TS₁) erfolgt nicht, da die Sättigung ja global erfolgen soll, d. h. das Wirkvolumen V₂ ist hier das gesamte Volumen im Messraum. In Figur 4 ist dargestellt, wie beispielsweise bei dieser Teilsequenz TS₂ die Amplitude A und die Frequenz F für das aktuelle Wirkvolumen V₂ optimiert werden.

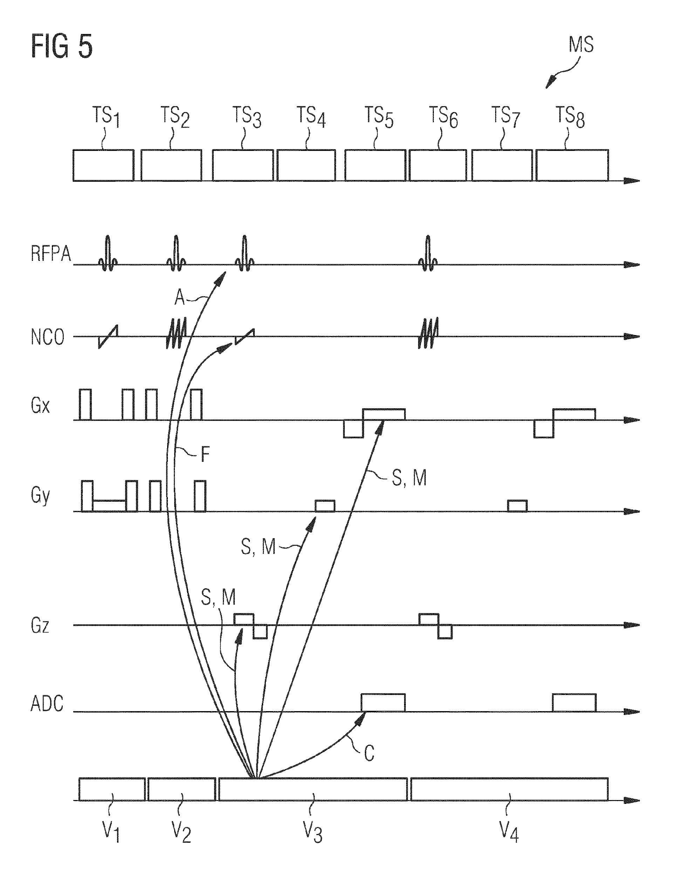

Nach dieser chemischen Sättigung TS₂ erfolgt dann die eigentliche Erfassung von Rohdaten für eine erste Schicht mittels dreier Teilsequenzen TS₃, TS₄, TS₅, welche alle auf die betreffende Schicht wirken müssen. Diese Schicht bestimmt das zugehörige Wirkvolumen V₃. Die erste Teilsequenz TS₃ dient dabei zur Schichtanregung im Wirkvolumen V₃. Dies erfolgt durch Aussenden eines Hochfrequenzpulses HF mit einer bestimmten Amplitude und einer vom NCO vorgegebenen Frequenz unter gleichzeitiger Aussendung eines Gz-Schichtgradientenpulses und eines nachfolgenden kürzeren, negativen Gz-Rephasierungs-Pulses. Die nächste Teilsequenz TS₄ dient der Phasenkodierung. Hierzu wird lediglich ein Gy-Gradientenpuls geschaltet. In der nachfolgenden Teilsequenz TS₅ erfolgt das Auslesen der im Wirkvolumen V₃ erzeugten Magnetresonanzsignale, indem zunächst ein negativer Gx-Gradientenpuls zur Dephasierung und anschließend ein positiver Gx-Gradientenpuls zur Rephasierung ausgesendet wird, wobei gleichzeitig der ADC zum Auslesen aktiviert wird. Danach ist das Ausmessen dieser Schicht beendet. Optimierbare Parameter sind dabei in Figur 5 wieder anhand von Pfeilen dargestellt: die Amplitude A des ausgesendeten Hochfrequenzpulses, die bei der Ausgabe des Hochfrequenzpulses eingestellte Phase und Frequenz F des NCO sowie bei der Schaltung der Gradientenpulse Gx, Gy, Gz jeweils wieder die Parameter für den Shim-Offset S und die Maxwell-Korrektur-Parameter M. Bezüglich des ADC kann eine Optimierung dahingehend erfolgen, dass - sofern verschiedene Auslesespulen (beispielsweise mehrere Lokalspulen) zur Verfügung stehen - die für das betreffende Wirkvolumen V₃ beste Spulenkombination ausgewählt wird, was durch den Spulenauswahlparameter C symbolisiert wird.

Anschließend an die Teilsequenz TS₅, mit der die Daten aus dem Volumen V₃ ausgelesen werden, kann dann innerhalb der Teilsequenz TS₆ eine Anregung einer weiteren Schicht erfolgen. Diese weitere Schicht ist hier durch das Wirkvolumen V₄ dargestellt. In gleicher Weise wie bei der ersten Schicht, d. h. bei dem Wirkvolumen V₃, erfolgt zur Ermittlung der Bilddaten auch bei dem Wirkvolumen V₄ dann eine Teilsequenz TS₇ zur Phasenkodierung und eine weitere Teilsequenz TS₈ zum Auslesen der Schicht.

Es ist klar, dass in der gleichen Weise noch weitere Schichten ausgelesen werden können, wobei entsprechende Teilsequenzen wiederholt werden müssen. Ebenso können in beliebiger Weise auch zwischen dem Ausmessen von Schichten weitere Sättigungs-Teilsequenzen oder andere spezielle Teilsequenzen eingefügt werden, beispielsweise zum Labeln bzw. Markieren von Blut oder anderen Flüssigkeiten, deren Verlauf im Körper später festgestellt werden soll. Entsprechend der Vielzahl der verschiedensten möglichen Teilsequenzen und zugehörigen Wirkvolumina ergeben sich auch die unterschiedlichsten Möglichkeiten, Parameter der verschiedenen Teilsysteme für die einzelnen Teilsequenzen im Hinblick auf die zugeordneten Wirkvolumina zu optimieren.

Es wird abschließend noch einmal darauf hingewiesen, dass es sich bei den vorbeschriebenen Aufbauten lediglich um Ausführungsbeispiele handelt und dass das Grundprinzip auch in weiten Bereichen vom Fachmann variiert werden kann, ohne den Bereich der Erfindungsidee zu verlassen. Es wird der Vollständigkeit halber auch darauf hingewiesen, dass die Verwendung der unbestimmten Artikel "ein" bzw. "eine" nicht ausschließt, dass die betreffenden Merkmale auch mehrfach vorhanden sein können. Ebenso schließt der Begriff "Einheit" nicht aus, dass diese aus mehreren Komponenten besteht, die gegebenenfalls auch räumlich verteilt sein können.

## Patentansprüche

1. Verfahren zum Betrieb eines bildgebenden medizinischen Untersuchungsgeräts (1) mit einer Mehrzahl an Teilsystemen (4, 5, 6, 7, 8, 14, 15, 16, 17, 18) und einer Steuereinrichtung (10), welche die Teilsysteme (4, 5, 6, 7, 8, 14, 15, 16, 17, 18) zur Durchführung einer Messsequenz koordiniert ansteuert, umfassend die Schritte:
- Übermitteln eines zu einer durchzuführenden Messung zugeordneten Steuerprotokolls (SP) an die Steuereinrichtung (10),
- Bestimmen von für das Steuerprotokoll (SP) relevanten Sequenzsteuerdaten (SD), welche verschiedene funktionelle Teilsequenzen (TS₁, TS₂, TS₃, TS₄, TS₅, TS₆, TS₇, TS₈) einer zu dem Steuerprotokoll (SP) gehörigen Messsequenz definieren,
- Zuordnen von unterschiedlichen Wirkvolumina (V₁, V₂, V₃, V₄, WV₁, WV₂, WV₃) zu jeder funktionellen Teilsequenz (TS₁, TS₂, TS₃, TS₄, TS₅, TS₆, TS₇, TS₈),
- Bestimmen von für die bestimmten relevanten Sequenzsteuerdaten und zugeordneten Wirkvolumina (V₁, V₂, V₃, V₄, WV₁, WV₂, WV₃) maßgeblichen, aktuellen Umgebungsbedingungen des bildgebenden medizinischen Untersuchungsgeräts,
- Berechnen und Speichern von Steuersignalen (ST) für die Messsequenz auf Basis der bestimmten Sequenzsteuerdaten, der Wirkvolumina (V₁, V₂, V₃, V₄, WV₁, WV₂, WV₃) und der bestimmten aktuellen Umgebungsbedingungen, derart dass die funktionellen Teilsequenzen (TS₁, TS₂, TS₃, TS₄, TS₅, TS₆, TS₇, TS₈) der Messsequenz zumindest hinsichtlich eines Teilbereichs ihres zugeordneten Wirkvolumens (V₁, V₂, V₃, V₄, WV₁, WV₂, WV₃) lokal optimiert werden,
- Starten einer Messung gemäß dem Steuerprotokoll (SP) unter Verwendung der gespeicherten Steuersignale (ST).

2. Verfahren nach Anspruch 1, wobei die Berechnung der Steuersignale (ST) eine Plausibilitätsprüfung (PP) umfasst.

3. Verfahren nach einem der Ansprüche 1 oder 2, wobei die Plausibilitätsprüfung (PP) einzuhaltende Schwellwerte, beispielsweise systembedingte und/oder qualitätsbezogene Schwellwerte, für die Sequenzsteuerdaten (SD) umfasst.

4. Verfahren nach einem der vorhergehenden Ansprüche, wobei die Plausibilitätsprüfung (PP) für verschiedene Wirkvolumen (V₁, V₂, V₃, V₄, WV₁, WV₂, WV₃) berechnete Steuersignale (ST) zueinander in Bezug setzt.

5. Verfahren nach einem der vorhergehenden Ansprüche, wobei die Bestimmung der relevanten Sequenzsteuerdaten (SD) eine Einteilung der Sequenzsteuerdaten (SD) in statisch einzustellende Sequenzsteuerdaten und dynamisch anzupassende Sequenzsteuerdaten umfasst.

6. Verfahren nach einem der vorhergehenden Ansprüche, wobei im Verlauf der Messung stets das aktuelle Wirkvolumen (V₁,
V₂, V₃, V₄, WV₁, WV₂, WV₃) der Messsequenz ermittelt wird.

7. Verfahren nach einem der vorhergehenden Ansprüche, wobei die lokale Optimierung der funktionellen Teilsequenzen (TS₁, TS₂, TS₃, TS₄, TS₅, TS₆, TS₇, TS₈) mittels einer zentralen Optimierungseinrichtung (21) der Steuereinrichtung (10) erfolgt, welcher Wirkvolumen-Positionsdaten (PD) übermittelt werden, welche eine Lage und Ausdehnung der den verschiedenen funktionellen Teilsequenzen (TS₁, TS₂, TS₃, TS₄, TS₅, TS₆, TS₇, TS₈) zugeordneten Wirkvolumina (V₁, V₂, V₃, V₄, WV₁, WV₂, WV₃) definieren.

8. Verfahren nach einem der vorhergehenden Ansprüche, wobei die lokale Optimierung einer funktionellen Teilsequenz (TS₁, TS₂, TS₃, TS₄, TS₅, TS₆, TS₇, TS₈) hinsichtlich eines innerhalb des zugeordneten Wirkvolumens (WV₁, WV₂) liegenden Optimierungsvolumens (OV₁, OV₂) erfolgt.

9. Verfahren nach einem der vorhergehenden Ansprüche, wobei das Optimierungsvolumen für eine funktionelle Teilsequenz durch Bildung einer Schnittmenge des der funktionellen Teilsequenz zugeordneten Wirkvolumens mit einem Objektvolumen, welches Objektinformationen über ein Untersuchungsobjekt enthält, ermittelt wird.

10. Bildgebendes medizinisches Untersuchungsgerät mit einer Mehrzahl von Teilsystemen (4, 5, 6, 7, 8, 14, 15, 16, 17, 18) und einer Steuereinrichtung (10), wobei die Steuereinrichtung (10) ausgebildet ist, um die Teilsysteme (4, 5, 6, 7, 8, 14, 15, 16, 17, 18) zur Durchführung einer Messsequenz (MS) auf Basis von Sequenzsteuerdaten (SD) koordiniert anzusteuern, wobei die Sequenzsteuerdaten (SD) verschiedene funktionelle Teilsequenzen (TS₁, TS₂, TS₃, TS₄, TS₅, TS₆, TS₇, TS₈) der Messsequenz (MS) definieren, denen unterschiedliche Wirkvolumina (V₁, V₂, V₃, V₄, WV₁, WV₂, WV₃) zugeordnet sind,
und wobei die Steuereinrichtung (10) zur Durchführen eines Verfahrens nach einem der Ansprüche 1 bis 9 ausgebildet ist.

11. Bildgebendes medizinisches Untersuchungsgerät nach Anspruch 10, wobei das Untersuchungsgerät ein Magnetresonanzgerät ist.

12. Computerprogramm, das ein Verfahren nach einem der Ansprüche 1 bis 9 auf einer Steuereinrichtung (10) implementiert, wenn es auf der Steuereinrichtung (10) ausgeführt wird.

13. Elektronisch lesbarer Datenträger (26) mit darauf gespeicherten elektronisch lesbaren Steuerinformationen, welche zumindest ein Computerprogramm nach Anspruch 12 umfassen und derart ausgestaltet sind, dass sie bei Verwendung des Datenträgers (26) in einer Steuereinrichtung (10) eines bildgebenden medizinischen Untersuchungsgeräts (1) ein Verfahren nach einem der Ansprüche 1 bis 9 durchführen.
